# EUROPEAN PATENT APPLICATION

(11) **EP 4 395 172 A1**
(43) Date of publication of application: **03.07.2024**
(21) Application number: 22880131.2
(22) Date of filing: 23.09.2022
(51) Int. Cl.: H03H 9/17, H03H 9/02

(54) **BULK ACOUSTIC WAVE RESONANT STRUCTURE AND PREPARATION METHOD THEREFOR, AND ACOUSTIC WAVE DEVICE**

(30) Priority: 15.10.2021 US 202163262586 P
(71) Applicant: Wuhan Yanxi Micro Components Co., Ltd., Wuhan, Hubei 430205 (CN)
(72) Inventor: ZHANG, Dapeng, Wuhan, Hubei 430205 (CN); LIN, Re-Ching, Wuhan, Hubei 430205 (CN); LIAO, Pei-Chun, Wuhan, Hubei 430205 (CN); HUANG, Wei-sheng, Wuhan, Hubei 430205 (CN); KOH, Zhi Wei, Wuhan, Hubei 430205 (CN)
(74) Representative: Brevalex
(86) International application number: PCT/CN2022/121118
(87) International publication number: WO 2023/061191

(57) **Abstract**

Provided in the embodiments of the present disclosure are a bulk acoustic wave resonant structure and a preparation method therefor, and an acoustic wave device. The bulk acoustic wave resonant structure comprises: a substrate; and a reflection structure, a first electrode, a piezoelectric layer and a second electrode which are sequentially located on the substrate, wherein an overlapping region of an orthographic projection of the first electrode on the substrate, an orthographic projection of the piezoelectric layer on the substrate and an orthographic projection of the second electrode on the substrate is a first overlapping region; the first electrode comprises a first portion, a second portion and a third portion, the second portion being connected to the first portion and the third portion; an orthographic projection of the first portion on the substrate falls within the first overlapping region, and the first portion extends in a direction parallel to a surface of the substrate; an orthographic projection of the second portion on the substrate and an orthographic projection of the third portion on the substrate fall within a region outside the first overlapping region, the second portion has an inclination angle relative to the surface of the substrate, and the third portion extends in a direction parallel to the surface of the substrate; and the first portion is higher than the third portion in a direction perpendicular to the surface of the substrate.

## Description

### CROSS-REFERENCE TO RELATED APPLICATIONS

The application is based on and claims priority to U.S. Provisional Patent Application No. 63/262, 586 filed on October 15, 2021, the entire content of which is incorporated herein by reference in its entirety.

### TECHNICAL FIELD

The disclosure relates to the field of semiconductor technology, and in particular to a bulk acoustic wave resonance structure and a preparation method of a bulk acoustic wave resonance structure, and an acoustic wave device.

### BACKGROUND

In widely used communication devices (such as cellular telephones), acoustic wave devices using acoustic waves are generally included as filters of communication devices. As examples of acoustic wave devices, there are devices using a Surface Acoustic Wave (SAW), or devices using a Bulk Acoustic Wave (BAW), or the like. The performance of acoustic wave devices has an influence on the communication effect of the communication devices.

With the development of communication technology, how to improve the performance of acoustic wave devices while conforming to the development trend of integration and miniaturization of communication devices has become an urgent problem.

### SUMMARY

In a first aspect, an embodiment of the disclosure provides a bulk acoustic wave resonance structure. The bulk acoustic wave resonance structure includes a substrate; and a reflection structure, a first electrode, a piezoelectric layer, and a second electrode that are sequentially located on the substrate. Here, an overlapping region of an orthographic projection of the first electrode on the substrate, an orthographic projection of the piezoelectric layer on the substrate, and an orthographic projection of the second electrode on the substrate is a first overlapping region. The first electrode includes a first portion, a second portion and a third portion, and the second portion connects the first portion and the third portion. An orthographic projection of the first portion on the substrate falls into the first overlapping region, and the first portion extends along a direction parallel to a surface of the substrate. An orthographic projection of the second portion on the substrate and an orthographic projection of the third portion on the substrate fall into a region outside the first overlapping region, the second portion has an inclination angle with respect to the surface of the substrate, and the third portion extends along the direction parallel to the surface of the substrate.

The first portion is higher than the third portion in a direction perpendicular to the surface of the substrate.

In a second aspect, an embodiment of the disclosure provides an acoustic wave device. The acoustic wave device includes the bulk acoustic wave resonance structure according to the above embodiment.

In a third aspect, an embodiment of the disclosure provides a preparation method of a bulk acoustic wave resonance structure. The method includes the following operations.

A substrate is provided, and a sacrificial layer is formed on a surface of the substrate.

A groove is formed in the sacrificial layer.

A first electrode that covers the groove and extends to a surface of the sacrificial layer is formed. The first electrode includes a first portion, a second portion and a third portion. The second portion connects the first portion and the third portion, the third portion covers a bottom of the groove, the first portion extends along a direction parallel to the surface of the substrate, and the second portion has an inclination angle with respect to the surface of the substrate.

A piezoelectric layer covering the sacrificial layer and the first electrode is formed.

A second electrode is formed on a side, remote from the substrate, of the piezoelectric layer.

At least one etch hole that penetrates through the piezoelectric layer is formed, and the sacrificial layer is released through the etch hole to form a reflection structure.

In a fourth aspect, an embodiment of the disclosure provides a preparation method of a bulk acoustic wave resonance structure. The method includes the following operations.

A substrate is provided, and a sacrificial layer is formed on a surface of the substrate.

An opening that penetrates through the sacrificial layer is formed, to form a first sacrificial structure and a second sacrificial structure that are separated.

A first electrode that covers the opening and extends to a surface of the second sacrificial structure is formed. The first electrode includes a first portion, a second portion and a third portion. The second portion connects the first portion and the third portion, the third portion covers a bottom of the opening, the first portion extends along a direction parallel to the surface of the substrate, and the second portion has an inclination angle with respect to the surface of the substrate.

A piezoelectric layer covering the first sacrificial structure, the second sacrificial structure and the first electrode is formed.

A second electrode is formed on a side, remote from the substrate, of the piezoelectric layer.

At least one etch hole that penetrates through the piezoelectric layer is formed, and the first sacrificial structure is released through the etch hole to form a first gap.

The second sacrificial structure is released through the etch hole to form a reflection structure.

### BRIEF DESCRIPTION OF THE DRAWINGS

In the drawings, unless otherwise specified, the same reference sign throughout multiple drawings indicates the same or similar component or element. These drawings are not necessarily drawn to scale. It is to be understood that these drawings only depict some implementation modes disclosed according to the disclosure and should not be regarded as limitation of the scope of the disclosure.
FIG. 1 is a schematic top view of a bulk acoustic wave resonance structure according to an embodiment of the disclosure.
FIG. 2 is a first sectional schematic diagram of a bulk acoustic wave resonance structure according to an embodiment of the disclosure.
FIG. 3 is a second sectional schematic diagram of a bulk acoustic wave resonance structure according to an embodiment of the disclosure.
FIG. 4 is a third sectional schematic diagram of a bulk acoustic wave resonance structure according to an embodiment of the disclosure.
FIG. 5 is a fourth sectional schematic diagram of a bulk acoustic wave resonance structure according to an embodiment of the disclosure.
FIG. 6 is a fifth sectional schematic diagram of a bulk acoustic wave resonance structure according to an embodiment of the disclosure.
FIG. 7 is a sixth sectional schematic diagram of a bulk acoustic wave resonance structure according to an embodiment of the disclosure.
FIG. 8 is a seventh sectional schematic diagram of a bulk acoustic wave resonance structure according to an embodiment of the disclosure.
FIG. 9 is an eighth sectional schematic diagram of a bulk acoustic wave resonance structure according to an embodiment of the disclosure.
FIG. 10 is a ninth sectional schematic diagram of a bulk acoustic wave resonance structure according to an embodiment of the disclosure.
FIG. 11 is a tenth sectional schematic diagram of a bulk acoustic wave resonance structure according to an embodiment of the disclosure.
FIG. 12 is an eleventh sectional schematic diagram of a bulk acoustic wave resonance structure according to an embodiment of the disclosure.
FIG. 13 is a twelfth sectional schematic diagram of a bulk acoustic wave resonance structure according to an embodiment of the disclosure.
FIG. 14 is a thirteenth sectional schematic diagram of a bulk acoustic wave resonance structure according to an embodiment of the disclosure.
FIG. 15 is a fourteenth sectional schematic diagram of a bulk acoustic wave resonance structure according to an embodiment of the disclosure.
FIG. 16 is a first flowchart of a preparation method of a bulk acoustic wave resonance structure according to an embodiment of the disclosure.
FIG. 17a to FIG. 17c are first sectional schematic diagrams of a process of a preparation method of a bulk acoustic wave resonance structure according to an embodiment of the disclosure.
FIG. 18 is a second flowchart of a preparation method of a bulk acoustic wave resonance structure according to an embodiment of the disclosure.
FIG. 19a to FIG. 19e are second sectional schematic diagrams of a process of a preparation method of a bulk acoustic wave resonance structure according to an embodiment of the disclosure.
FIG. 20a to FIG. 20e are third sectional schematic diagrams of a process of a preparation method of a bulk acoustic wave resonance structure according to an embodiment of the disclosure.
FIG. 21a to FIG. 21d are fourth sectional schematic diagrams of a process of a preparation method of a bulk acoustic wave resonance structure according to an embodiment of the disclosure.
FIG. 22a to FIG. 22f are fifth sectional schematic diagrams of a process of a preparation method of a bulk acoustic wave resonance structure according to an embodiment of the disclosure.
FIG. 23a to FIG. 23d are sixth sectional schematic diagrams of a process of a preparation method of a bulk acoustic wave resonance structure according to an embodiment of the disclosure.
FIG. 24 is a schematic diagram of a test result of a bulk acoustic wave resonance structure according to an embodiment of the disclosure.

### DETAILED DESCRIPTION

The technical solutions of the disclosure are described below in detail in combination with the drawings and specific embodiments.

In the embodiments of the disclosure, the terms "first", "second" or the like are used to distinguish similar objects, and are not used to describe a particular order or sequence.

In the embodiments of the disclosure, the term "A is in contact with B" includes a case where A is in direct contact with B, or a case where A is indirectly in contact with B with other components interposed between A and B.

In the embodiments of the disclosure, the term "layer" refers to a material part including a region with a thickness. A layer may extend on the entirety of an upper structure or a lower structure, or may have a scope that is smaller than the scope of the upper structure or the lower structure. In addition, a layer may be a region of a homogeneous or non-homogeneous continuous structure that a thickness of the layer is less than the thickness of a continuous structure. For example, a layer may be located between the top surface and the bottom surface of a continuous structure, or a layer may be located between any pair of horizontal planes at the top surface and bottom surface of the continuous structure. A layer may extend horizontally, vertically, and/or along an inclined surface. Further, a layer may include multiple sub-layers.

It is to be understood that the terms "on" "above" and "over" in the disclosure should be interpreted in the broadest manner such that "on" not only denotes "on" something without any intervening feature or layer (i.e., directly on something), but also "on" something with an intervening feature or layer.

Resonators include dielectric resonators, surface acoustic wave resonators, and bulk acoustic wave resonators. The large power capacity of dielectric resonators is the advantage of this technology, but the large size can not satisfy the development of chip miniaturization and integration well. In addition, currently in the field of mobile communication, frequency difference between different frequency bands is getting smaller, which makes higher requirements on signal selectivity of filters, and thus devices are required to have a higher quality factor (Q value).

Surface acoustic wave resonators have been widely used in commercial products due to higher operating frequency, low phase noise, high Q value, lower insertion loss, and simple preparation process below 2GHz frequency band. However, with the development of 5G communication, the application of surface acoustic wave resonators in the field of high-frequency communication has been limited due to the size limitation of interdigitated electrodes.

The resonance frequency of a bulk acoustic wave resonator depends on various factors, such as the piezoelectric material, different production methods, and the influence of the manufacturing process, especially the material thickness of the piezoelectric material. Bulk acoustic wave resonators may achieve an operating frequency far higher than that of surface acoustic wave resonators, and the size shrinks as the frequency increases. Therefore, bulk acoustic wave resonators have an advantage of smaller size, and play an important role in the field of communication. The Film Bulk Acoustic Resonator (FBAR), as a branch of bulk acoustic wave resonator, has been greatly improved with the development of communication technology, and the related filters and duplexers have achieved a commercial large-scale application in the field of high-frequency communication.

There are many parameters to measure the performance of a film bulk acoustic resonator, and the main parameters include the quality factor (Q value). When electrical energy is applied to the upper and lower electrodes of a bulk acoustic wave resonator, the piezoelectric layers located in the upper and lower electrodes generate acoustic waves due to the piezoelectric effect. In addition to longitudinal waves, transverse shear waves (also referred to as lateral waves or shear waves) are generated in the piezoelectric layers. The presence of transverse shear waves affects the energy of the main longitudinal waves, and the transverse shear waves cause energy loss and deteriorate the Q value of the bulk acoustic wave resonator.

For example, in a mobile terminal, there is a case where multiple frequency bands are used simultaneously, which requires the filter or duplexer in the mobile terminal to have steeper skirts and less insertion loss. The performance of a filter is determined by the resonator that forms the filter, and increasing the Q value of the resonator may achieve steeper skirts and less insertion loss. In addition, excessive parasitic resonance of the resonator may adversely affect the performance of the filter or duplexer.

In view of this, how to reduce the parasitic resonance of the bulk acoustic wave resonator and improve the Q value of the bulk acoustic wave resonator has become an urgent problem.

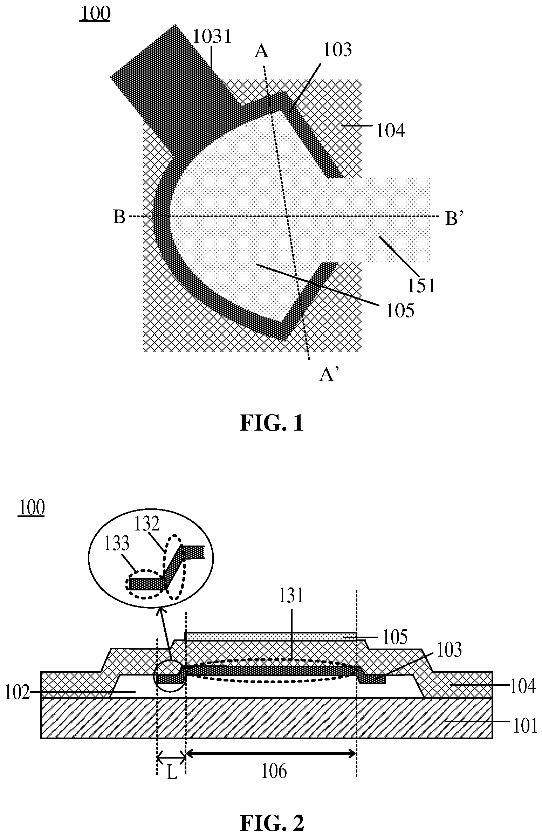

FIG. 1 is a schematic top view of a bulk acoustic wave resonance structure 100 according to an embodiment of the disclosure, and FIG. 2 is a sectional schematic diagram of the bulk acoustic wave resonance structure 100 illustrated according to FIG. 1 along the AA' direction. Referring to FIG. 2, the bulk acoustic wave resonance structure 100 includes a substrate 101; and a reflection structure 102, a first electrode 103, a piezoelectric layer 104, and a second electrode 105 that are sequentially located on the substrate 101. The overlapping region of the orthographic projection of the first electrode 103 on the substrate 101, the orthographic projection of the piezoelectric layer 104 on the substrate 101, and the orthographic projection of the second electrode 105 on the substrate 101 is a first overlapping region 106. The first electrode 103 includes a first portion 131, a second portion 132 and a third portion 133, and the second portion 132 connects the first portion 131 and the third portion 133.

The orthographic projection of the first portion 131 on the substrate 101 falls into the first overlapping region 106, and the first portion 131 extends along a direction parallel to the surface of the substrate 101. The orthographic projection of the second portion 132 on the substrate 101 and the orthographic projection of the third portion 133 on the substrate 101 fall into a region outside the first overlapping region 106, the second portion 132 has an inclination angle with respect to the surface of the substrate 101, and the third portion 133 extends along the direction parallel to the surface of the substrate 101. The first portion 131 is higher than the third portion 133 in a direction perpendicular to the surface of the substrate 101.

It is to be noted that in order to illustrate the positions of all portions of the first electrode 103, the bulk acoustic wave resonance structure 100 illustrated in FIG. 2 is a local sectional schematic diagram highlighting the first electrode 103. In order to show all portions of the first electrode 103 more clearly, the second portion 132 and the third portion 133 of the first electrode 103 are locally enlarged in FIG. 2. The bulk acoustic wave resonance structure illustrated in FIG. 2 is only an example of the embodiments of the disclosure and is not used to limit the features of the bulk acoustic wave resonance structure in the embodiments of the disclosure. Other examples of the bulk acoustic wave resonance structure of the embodiments of the disclosure are shown in later embodiments. Here, FIG. 2 illustrates that the first electrode 103 is located between the piezoelectric layer 104 and the reflection structure 102, and the first electrode 103 is not in contact with the substrate 101.

In a practical application, the composition material of the substrate 101 may include silicon (Si), germanium (Ge), or the like.

The first electrode 103 may be referred to as a lower electrode, and correspondingly, the second electrode 105 may be referred to as an upper electrode. Electrical energy may be applied to the bulk acoustic wave resonance structure 100 through the upper electrode and lower electrode. The composition materials of the first electrode 103 and the second electrode 105 may be the same; and the composition material may include conductive metals such as aluminum (Al), molybdenum (Mo), ruthenium (Ru), iridium (Ir), chromium (Cr), or platinum (Pt), or conductive materials consist of alloys of the above conductive metals. Exemplarily, the composition materials of the first electrode 103 and the second electrode 105 are both molybdenum (Mo).

The piezoelectric layer 104 may be used to generate vibrations according to inverse piezoelectric characteristics, and convert electrical signals applied to the first electrode 103 and the second electrode 105 into acoustic wave signals, which realizes the conversion from electrical energy to mechanical energy.

In a practical application, the composition material of the piezoelectric layer 104 includes a material having piezoelectric characteristics, for example, aluminum nitride, zinc oxide, lithium tantalate, lead zirconate titanate, barium titanate, or the like. The composition material of the piezoelectric layer 104 may further include a material having piezoelectric characteristics by doping, which may be doped with a transition metal or a rare metal, for example, scandium-doped aluminum nitride, or the like.

Here, the reflection structure 102 is used to reflect acoustic wave signals. When an acoustic wave signal generated by the piezoelectric layer 104 propagates toward the reflection structure 102, the acoustic wave signal may be totally reflected at the interface where the first electrode 103 and the reflection structure 102 are in contact, to able the acoustic wave signal to be reflected back into the piezoelectric layer 104. In this way, the energy of the acoustic wave signals generated by the piezoelectric layer 104 can be confined within the piezoelectric layer 104, thereby reducing energy loss of acoustic wave signals and increasing acoustic wave energy of the main resonance mode of the bulk acoustic wave resonance structure.

It is to be noted that the bulk acoustic wave resonance structure illustrated in FIG. 1 is only an example provided by the disclosure. In a practical application, according to different forms of the reflection structure 102, bulk acoustic wave resonance structures may be specifically classified as: a first type of cavity-type Film Bulk Acoustic Wave Resonator (FBAR), a second type of cavity-type FBAR, Solid Mounted Resonator (SMR), or the like. The solutions provided by the embodiments of the disclosure may apply to the above different types of bulk acoustic wave resonance structures.

Exemplarily, in case that the bulk acoustic wave resonance structure includes a first type of cavity-type FBAR, the reflection structure 102 includes a first cavity formed between the upwardly protruded first electrode 103 and the surface of the substrate 101. In case that the bulk acoustic wave resonance structure includes a second type of cavity-type FBAR, the reflection structure 102 includes a second cavity formed between the downwardly recessed surface of the substrate 101 and the first electrode 103. Here, the case where the bulk acoustic wave resonance structure 100 includes a first type of cavity-type FBAR is illustrated as an example.

In a practical application, as illustrated in FIG. 2, the overlapping region of the orthographic projection of the first electrode 103 on the substrate 101, the orthographic projection of the piezoelectric layer 104 on the substrate 101, and the orthographic projection of the second electrode 105 on the substrate 101 is a first overlapping region 106. The first overlapping region 106 may be referred to as a resonance region or an active region, and the region outside the first overlapping region 106 may be referred to as a non-resonance region. The effective region (or the main resonance region) of the resonance region is the first overlapping region 106, and the main resonance mode of the bulk acoustic wave resonance structure is generated within the first overlapping region 106.

As illustrated in FIG. 2, a second portion 132 that has an inclination angle with respect to the surface of the substrate 101 is set close to the edge (the non-resonance region) of the first overlapping region 106. Exemplarily, a range of the inclination angle of the second portion 132 is from 10° to 80°. The inclination angle may also be improved according to the design dimensions of the bulk acoustic wave resonance structure. The first electrode 103 has a slope (i.e., the second portion 132), and the slope is set to able that the distance from the edge of the second electrode 105 to the edge of the first electrode 103 becomes longer. In this way, the electric field line from the second electrode 105 to the first electrode 103 becomes longer, resulting in a decrease in the electric field intensity of the non-resonance region. Due to the decrease of the electric field intensity, the electric displacement is reduced and the effect of piezoelectric resonance is reduced, such that the parasitic resonance close to the edge of the first overlapping region 106 (i.e., which may be inside the resonance region or outside the resonance region) is reduced to reduce the propagation of the parasitic resonance to the resonance region, thereby improving the Q value of the bulk acoustic wave resonance structure.

In an embodiment, the composition materials of the first portion 131, the second portion 132, and the third portion 133 are the same, for example, the composition material of the first portion 131, the second portion 132, and the third portion 133 includes molybdenum (Mo). In another embodiment, the composition materials of the first portion 131 and the second portion 132 are different, and the composition materials of the second portion 132 and the third portion 133 are the same, for example, the composition material of the first portion 131 includes aluminum (Al), and the composition material of the second portion 132 and the third portion 133 includes molybdenum (Mo).

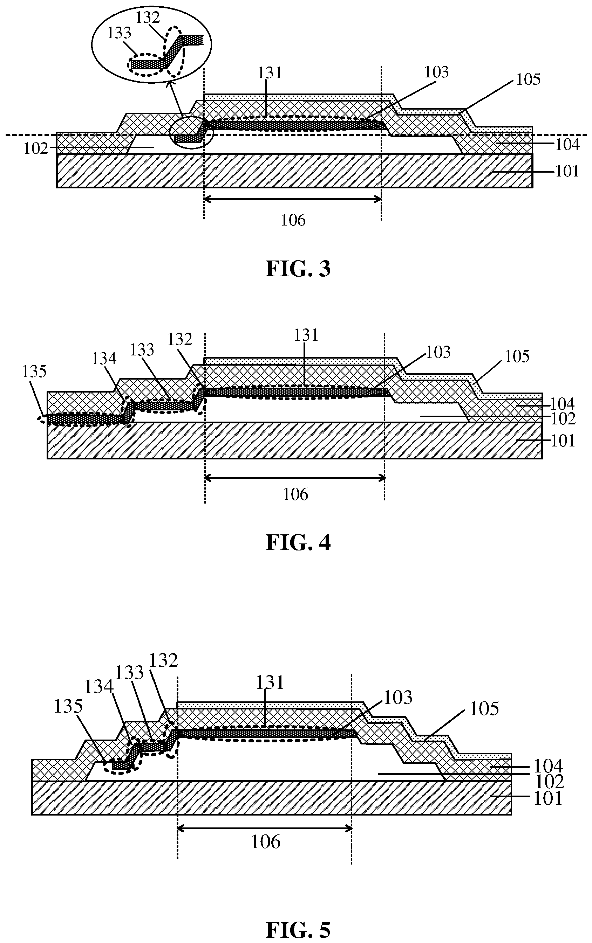

FIG. 3 is a second sectional schematic diagram of a bulk acoustic wave resonance structure according to an embodiment of the disclosure. FIG. 3 is a local sectional schematic diagram of the bulk acoustic wave resonance structure 100 illustrated according to FIG. 1 along the BB' direction. In order to illustrate all portions of the first electrode 103 more clearly, the second portion 132 and the third portion 133 of the first electrode 103 are locally enlarged in FIG.3. It is to be noted that FIG. 2 and FIG. 3 illustrate two different reflection structures 102. As illustrated in FIG. 2, the height of the reflection structure 102 in the first overlapping region 106 is the same as the height of the reflection structure 102 in the region outside the first overlapping region 106. As illustrated in FIG. 3, the height of the reflection structure 102 in the first overlapping region 106 is greater than the height of the reflection structure 102 in the region outside the first overlapping region 106. It is to be understood that the reflection structure 102 of the bulk acoustic wave resonance structure illustrated in FIG. 3 may further increase the distance between the first electrode 103 and the second electrode 105 in the region (the non-resonance region) outside the first overlapping region 106, thereby weakening the electric field of the non-resonance region.

In the embodiment of the disclosure, in the region outside the first overlapping region 106, i.e., the non-resonance region, by setting a first electrode 103 that has a slope, the distance between the first electrode 103 and the second electrode 105 close to the edge (the non-resonance region) of the first overlapping region 106 is increased, which a decrease in the electric field intensity of the non-resonance region adjacent to the first overlapping region 106 can be realized, such that the parasitic resonance close to the edge of the first overlapping region 106 is reduced to reduce the propagation of the parasitic resonance to the resonance region, thereby improving the Q value of the bulk acoustic wave resonance structure.

In some embodiments, referring to FIG. 4, the first electrode 103 further includes a fourth portion 134 and a fifth portion 135. The orthographic projection of the fourth portion 134 on the substrate 101 and the orthographic projection of the fifth portion 135 on the substrate 101 fall into the region outside the first overlapping region 106, the fourth portion 134 has an inclination angle with respect to the surface of the substrate 101, and the fifth portion 135 extends along the direction parallel to the surface of the substrate 101. The fourth portion 134 connects the third portion 133 and the fifth portion 135, the third portion 133 is higher than the fifth portion 135 in the direction perpendicular to the surface of the substrate 101, and the fifth portion 135 is located between the piezoelectric layer 104 and the substrate 101.

It is to be noted that the first electrode 103 includes at least one slope. Exemplarily, the first electrode 103 may have two slopes (for example, the second portion 132 and the fourth portion 134 as illustrated in FIG. 4 or FIG. 5), and the fifth portion 135 of the first electrode 103 is located between the piezoelectric layer 104 and the substrate 101. In an embodiment, as illustrated in FIG. 4, the fifth portion 135 is in direct contact with the substrate 101. In another embodiment, as illustrated in FIG. 5, the fifth portion 135 is not in contact with the substrate 101.

Specifically, as illustrated in FIG. 4, the first electrode 103 has two slopes (for example, the second portion 132 and the fourth portion 134 in FIG. 4), and the reflection structure 102 has two slopes. The second portion 132 and the fourth portion 134 of the first electrode 103 extend along the slopes of the reflection structure 102. In this way, the fifth portion 135 is in direct contact with the substrate 101.

As illustrated in FIG. 5, the first electrode 103 has two slopes (for example, the second portion 132 and the fourth portion 134 in FIG. 5), and the reflection structure 102 has three slopes. The second portion 132 and the fourth portion 134 of the first electrode 103 extend along two of the three slopes of the reflection structure 102. In this way, the fifth portion 135 is not in contact with the substrate 101.

Exemplarily, a range of the inclination angle of the second portion 132 and a range of the inclination angle of the fourth portion 134 are from 10° to 80°. The inclination angles of the second portion 132 and the fourth portion 134 may be the same or different. The inclination angle may also be improved according to the design dimensions of the bulk acoustic wave resonance structure.

In the embodiment of the disclosure, the first electrode 103 has multiple slopes (for example, two slopes). Compared to the manner in which the first electrode 103 is set with only one slope, in the disclosure, by setting a first electrode 103 that has multiple slopes, the distance between the first electrode 103 and the second electrode 105 in the non-resonance region may be further increased, and the electric field intensity of the non-resonance region adjacent to the first overlapping region 106 can be decreased, such that the parasitic resonance close to the edge of the first overlapping region 106 is reduced to reduce the propagation of the parasitic resonance to the resonance region, thereby improving the Q value of the bulk acoustic wave resonance structure. It is to be noted that compared to the manner in which the first electrode 103 is set with multiple slopes, the process of the manner in which the first electrode 103 is set with only one slope is simpler and easier to implement, which may save the cost and simplify the preparation process.

In some embodiments, referring to FIG. 4, the fifth portion 135 is in direct contact with the substrate 101.

Exemplarily, as illustrated in FIG. 4, the second portion 132 and the fourth portion 134 of the first electrode 103 extend along the slope(s) of the reflection structure 102, and the fifth portion 135 extends to the surface of the substrate 101 and is in direct contact with the substrate 101. In this way, the first electrode 103 extends to be in direct contact with the substrate 101, which makes the bulk acoustic wave resonance structure more stable. In addition, the direct contact between the first electrode 103 and the substrate 101 can realize the heat dissipation through the substrate 101, which further improves the performance of the bulk acoustic wave resonance structure.

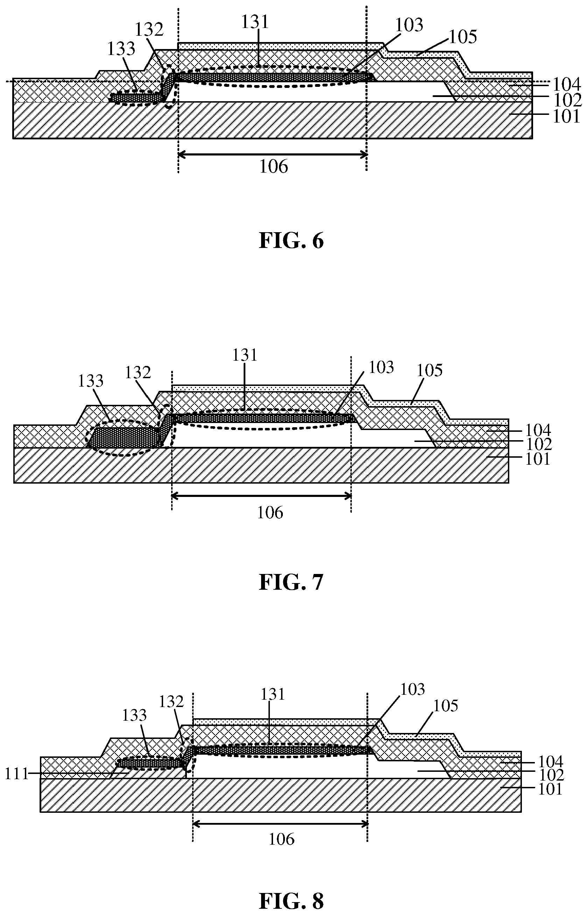

In some embodiments, referring to FIG. 6, the third portion 133 is located between the piezoelectric layer 104 and the substrate 101, and the third portion 133 is in direct contact with the substrate 101.

A side (remote from the first overlapping region 106) of the third portion 133 is in contact with the piezoelectric layer 104.

As illustrated in FIG. 6, the first electrode 103 has a slope (i.e., the second portion 132). The third portion 133 extends to the surface of the substrate 101 and is in direct contact with the substrate 101. In this way, the first electrode 103 extends to be in contact with the substrate 101, which makes the bulk acoustic wave resonance structure more stable. In addition, the direct contact between the first electrode 103 and the substrate 101 can realize the heat dissipation through the substrate 101, which further improves the performance of the bulk acoustic wave resonance structure.

The third portion 133 is in direct contact with the substrate 101 and the piezoelectric layer 104, respectively. In this way, there is a good support between the first electrode 103 and the piezoelectric layer 104, which reduces the probability of fracture of the piezoelectric layer 104, thereby improving the stability of the bulk acoustic wave resonance structure and reducing anchor losses.

In some embodiments, referring to FIG. 7, the thickness of the third portion 133 in the direction perpendicular to the surface of the substrate 101 is greater than the thickness of the first portion 131 in the direction perpendicular to the surface of the substrate 101.

Exemplarily, the third portion 133 has a thickness of 2 µm in the direction perpendicular to the surface of the substrate 101, and the first portion 131 has a thickness of 1 µm in the direction perpendicular to the surface of the substrate 101. As illustrated in FIG. 7, the first electrode 103 has a slope (i.e., the second portion 132), and the thickened third portion 133 extends to the surface of the substrate 101 and is in direct contact with the substrate 101.

Compared to the consistency in thickness of all portions of the first electrode 103 of the bulk acoustic wave resonance structure illustrated in FIG. 6, in the embodiment of the disclosure, the thickened third portion 133 may further reduce the electrical loss of the first electrode 103, thereby improving the performance of the bulk acoustic wave resonance structure.

In some embodiments, referring to FIG. 8, the substrate 101 includes a first protrusion 111 that protrudes toward the third portion 133, and the first protrusion 111 is in direct contact with the third portion 133. A side (remote from the first overlapping region 106) of the first protrusion 111 is in contact with the piezoelectric layer 104, and a side (close to the first overlapping region 106) of the first protrusion 111 is in contact with the reflection structure 102.

As illustrated in FIG. 8, the thickness of each portion of the first electrode 103 of the bulk acoustic wave resonance structure is consistent. In order to ensure a direct contact between the first electrode 103 and the substrate 101 without changing the thickness of the first electrode 103, the first protrusion 111 is set on the substrate 101. Exemplarily, the composition materials of the first protrusion 111 and the substrate 101 are the same.

In the embodiment of the disclosure, the extended third portion 133 of the first electrode 103 is in direct contact with the first protrusion 111 of the substrate 101, which makes the bulk acoustic wave resonance structure more stable. The direct contact between the third portion 133 and the substrate 101 can realize the heat dissipation through the substrate 101, which further improves the performance of the bulk acoustic wave resonance structure. Compared to the bulk acoustic wave resonance structure illustrated in FIG. 7 in which the thickness of the third portion 133 is required to be increased, in the embodiment of the disclosure, there is no need to form a thickened third portion 133, and the consistent thickness of all portions of the first electrode 103 may be formed in the same step of the process, thereby saving the cost and simplifying the preparation process.

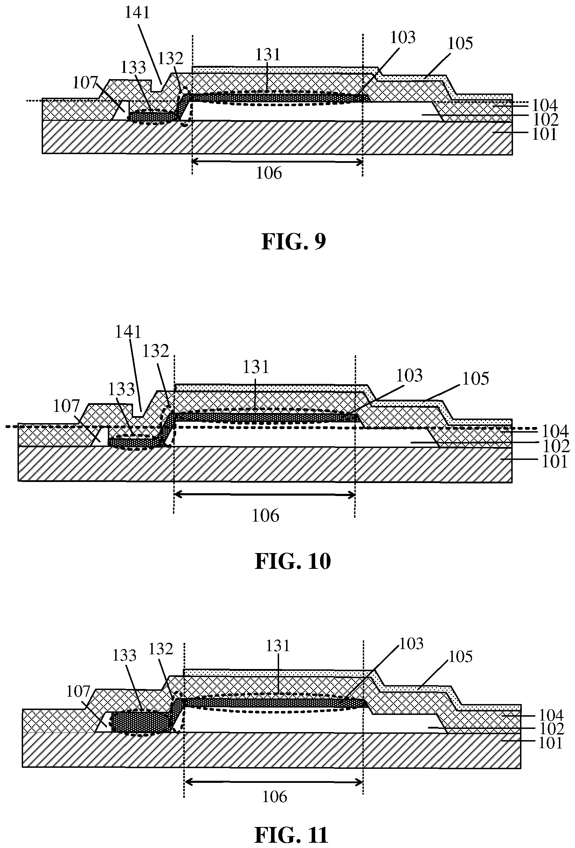

In some embodiments, referring to FIG. 9, the bulk acoustic wave resonance structure further includes a first gap 107 located between the piezoelectric layer 104 and the substrate 101. A side (remote from the first overlapping region 106) of the third portion 133 is in contact with the first gap 107.

In a practical application, the material of the first gap 107 includes air or a functional material for reflecting acoustic waves. Exemplarily, the first gap 107 may include a vacuum gap or may be other gas medium gaps. In case that the material of the first gap 107 includes air, a portion of the edge of the piezoelectric layer 104 may be exposed to air, thereby effectively suppressing the transverse shear waves. The first gap 107 may also be made of a functional material with low acoustic impedance, such as silicon carbide (SiC), silicon dioxide (SiO₂), or the like.

As illustrated in FIG. 9, the first gap 107 is located in the non-resonance region outside the first overlapping region 106. In this way, when a transverse shear wave propagates to the non-resonance region, the first gap 107 may reduce or even suppress the leakage of the transverse shear wave.

As illustrated in FIG. 9, a side (remote from the first overlapping region 106) of the third portion 133 is in contact with the first gap 107, and thus the first gap 107 is set at the edge of the extended third portion 133 of the first electrode 103. Exemplarily, the material of the first gap 107 includes air. The edge of the first electrode 103 is exposed to air, which may further weaken the electric field intensity of the non-resonance region, and reduce the parasitic resonance at the edge of the first overlapping region 106 to reduce the propagation of the parasitic resonance to the resonance region.

It is to be noted that FIG. 9 and FIG. 10 illustrate two different reflection structures 102. As illustrated in FIG. 9, the height of the reflection structure 102 in the first overlapping region 106 is the same as the height of the reflection structure 102 in the region outside the first overlapping region 106. As illustrated in FIG. 10, the height of the reflection structure 102 in the first overlapping region 106 is greater than the height of the reflection structure 102 in the region outside the first overlapping region 106. It is to be understood that the reflection structure 102 of the bulk acoustic wave resonance structure illustrated in FIG. 10 may further increase the distance between the first electrode 103 and the second electrode 105 in the region (the non-resonance region) outside the first overlapping region 106, thereby weakening the electric field intensity of the non-resonance region.

It is to be understood that the piezoelectric layer 104 as illustrated in FIG. 9 or FIG. 10 has a groove 141. The groove 141 is naturally formed according to the surface morphology underneath the piezoelectric layer 104 during the process of depositing the piezoelectric layer 104.

In the embodiment of the disclosure, the first gap 107 may reduce the leakage of transverse shear waves and increase the Q value of the bulk acoustic wave resonance structure. Preferably, the material of the first gap 107 includes air, which may further weaken the electric field intensity of the non-resonance region, and is more conducive to increasing acoustic wave energy of the main resonance mode of the bulk acoustic wave resonance structure.

In some embodiments, referring to FIG. 11, the first gap 107 has a first height in the direction perpendicular to the surface of the substrate 101, and the third portion 133 has a second height in the direction perpendicular to the surface of the substrate 101. The first height is equal to the second height, and the first height is less than a height of the reflection structure 102 within the first overlapping region 106 in the direction perpendicular to the surface of the substrate 101.

As illustrated in FIG. 11, the first electrode 103 has a slope (i.e., the second portion 132), and the thickened third portion 133 extends to the surface of the substrate 101 and is in direct contact with the substrate 101. A side (remote from the first overlapping region 106) of the third portion 133 is in contact with the first gap 107, and thus the first gap 107 is set at the edge of the extended third portion 133 of the first electrode 103. The edge of the first electrode 103 is exposed to air, which may further weaken the electric field intensity of the non-resonance region and reduce the parasitic resonance at the edge of the first overlapping region 106 to reduce the propagation of the parasitic resonance to the resonance region. Exemplarily, the third portion 133 has a second height of 2 µm in the direction perpendicular to the surface of the substrate 101, and the first gap 107 has a first height of 2 µm in the direction perpendicular to the surface of the substrate 101.

Compared to the consistency in thickness of all portions of the first electrode 103 of the bulk acoustic wave resonance structure illustrated in FIG. 9 or FIG. 10, in the embodiment of the disclosure, the first height of the first gap 107 in the direction perpendicular to the surface of the substrate 101 is equal to the second height of the third portion 133 in the direction perpendicular to the surface of the substrate 101, that is, the first electrode 103 has a thickened third portion 133, which may further reduce the electrode loss of the first electrode 103, and thereby improve the performance of the bulk acoustic wave resonance structure. In addition, the first gap 107 may reduce the leakage of transverse shear waves and increase the Q value of the bulk acoustic wave resonance structure. Preferably, the material of the first gap 107 includes air, which may further weaken the electric field intensity of the non-resonance region, and is more conducive to increasing acoustic wave energy of the main resonance mode of the bulk acoustic wave resonance structure.

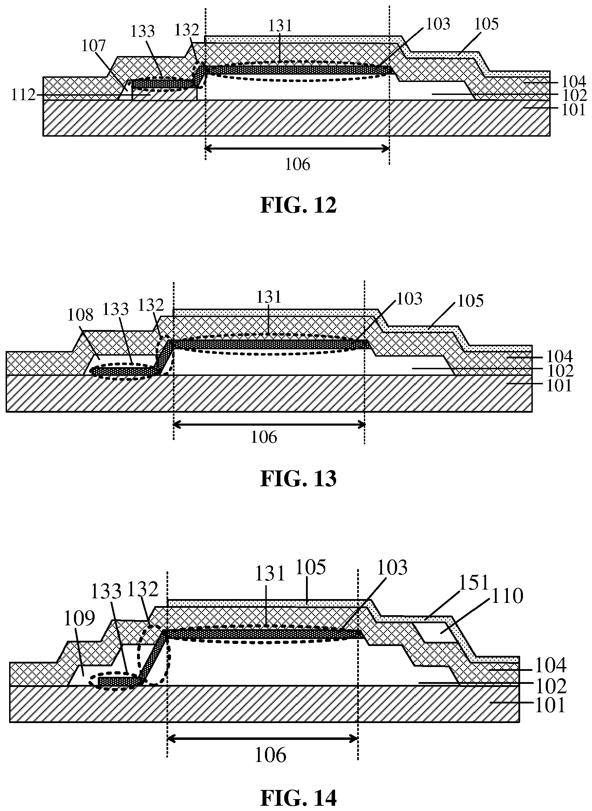

In some embodiments, referring to FIG. 12, the bulk acoustic wave resonance structure further includes a second protrusion 112 that protrudes toward the third portion 133. The second protrusion 112 is in direct contact with the third portion 133. The first gap 107 has a first height in the direction perpendicular to the surface of the substrate 101, the third portion 133 has a second height in the direction perpendicular to the surface of the substrate 101, and the second protrusion 112 has a third height in the direction perpendicular to the surface of the substrate 101. The first height is equal to the sum of the second height and the third height.

As illustrated in FIG. 12, the thickness of each portion of the first electrode 103 of the bulk acoustic wave resonance structure is consistent. In order to ensure a direct contact between the first electrode 103 and the substrate 101 without changing the thickness of the first electrode 103, the second protrusion 112 is set on the substrate 101. Exemplarily, the composition materials of the second protrusion 112 and the substrate 101 are the same.

Exemplarily, the case where the material of the first gap 107 includes air is illustrated as an example. As illustrated in FIG. 12, the first gap 107 is located in the non-resonance region outside the first overlapping region 106. In this way, when a transverse shear wave propagates to the non-resonance region, the first gap 107 may reduce or even suppress the leakage of the transverse shear wave.

As illustrated in FIG. 12, the first electrode 103 has a slope (i.e., the second portion 132), and the third portion 133 extends to the surface of the second protrusion 112 and is in direct contact with the second protrusion 112. A side (remote from the first overlapping region 106) of the third portion 133 is in contact with the first gap 107, and thus the first gap 107 is set at the edge of the extended third portion 133 of the first electrode 103. The edge of the first electrode 103 is exposed to air, which may further weaken the electric field intensity of the non-resonance region and reduce the parasitic resonance. Exemplarily, the first gap 107 has a first height of 2 µm in the direction perpendicular to the surface of the substrate 101, the third portion 133 has a second height of 1 µm in the direction perpendicular to the surface of the substrate 101, and the second protrusion 112 has a third height of 1 µm in the direction perpendicular to the surface of the substrate 101.

It is to be understood that in order to illustrate different bulk acoustic wave resonance structures on the substrate 101 in different embodiments, the protrusion on the substrate 101 is named the first protrusion 111 (as illustrated in FIG. 8) and the second protrusion 112 (as illustrated in FIG. 12) respectively. In a practical application, the first protrusion 111 and the second protrusion 112 may be the same protrusion on the substrate 101.

In the embodiment of the disclosure, the extended third portion 133 of the first electrode 103 is in direct contact with the second protrusion 112 of the substrate 101, which makes the bulk acoustic wave resonance structure more stable. The direct contact between the third portion 133 and the substrate 101 can realize the heat dissipation through the substrate 101, which further improves the performance of the bulk acoustic wave resonance structure. Compared to the bulk acoustic wave resonance structure illustrated in FIG. 11 in which the electrode thickness of the third portion 133 is required to be increased, in the embodiment of the disclosure, there is no need to form a thickened third portion 133, and the consistent thickness of all portions of the first electrode 103 may be formed in the same step of the process, thereby saving the cost and simplifying the preparation process.

In some embodiments, referring to FIG. 13, the bulk acoustic wave resonance structure further includes a second gap 108 located between the piezoelectric layer 104, and the second and the third portions (132, 133). A side (close to the first overlapping region 106) of the second gap 108 is in contact with the second portion 132; and a side (close to the substrate 101) of the second gap 108 is in contact with the third portion 133.

In a practical application, the material of the second gap 108 may be referred to the first gap 107 and will not be repeated herein.

As illustrated in FIG. 13, the second gap 108 is located in the non-resonance region outside the first overlapping region 106. In this way, when a transverse shear wave propagates to the non-resonance region, the second gap 108 may reduce or even suppress the leakage of the transverse shear wave.

As illustrated in FIG. 13, the second portion 132 and the third portion 133 of the first electrode 103 are in contact with the second gap 108. Exemplarily, the material of the second gap 108 includes air. The second portion 132 and the third portion 133 of the first electrode 103 are both exposed to air, which may further weaken the electric field intensity of the non-resonance region and reduce the parasitic resonance.

In the embodiment of the disclosure, the second gap 108 may reduce the leakage of transverse shear waves and increase the Q value of the bulk acoustic wave resonance structure. Preferably, the material of the second gap 108 includes air, which may further weaken the electric field intensity of the non-resonance region, and is more conducive to increasing acoustic wave energy of the main resonance mode of the bulk acoustic wave resonance structure. Compared to the first gap 107 that exposes the edge of the third portion 133 (for example, as illustrated in FIG. 12), the second gap 108 exposes the second portion 132 and the third portion 133 of the first electrode 103, which may further weaken the electric field intensity of the non-resonance region and reduce the parasitic resonance.

In some embodiments, referring to FIG. 1, the bulk acoustic wave resonance structure further includes an electrode lead 151 connected to the second electrode 105. The orthographic projection of the electrode lead 151 on the substrate 101 is located in the region outside the first overlapping region 106.

The second portion 132 and the third portion 133 are set around the first overlapping region 106, and the orthographic projection of the second portion 132 on the substrate 101 and the orthographic projection of the third portion 133 on the substrate 101 fall into a region outside the orthographic projection of the electrode lead 151 on the substrate 101.

Exemplarily, the electrode lead 151 is an upper electrode lead, the upper electrode lead is set in the same layer as the second electrode 105 (the upper electrode), and the upper electrode lead is connected to the second electrode 105 (the upper electrode). It is to be noted that the bulk acoustic wave resonator further includes a lower electrode lead 1031, the lower electrode lead 1031 is set in the same layer as the first electrode 103 (the lower electrode), and the lower electrode lead 1031 is connected to the first electrode 103 (the lower electrode).

In a practical application, the electrode lead 151 is connected to the second electrode 105, and the electrode lead 151 is an upper electrode lead. The first electrode 103 includes the first portion 131, the second portion 132, and the third portion 133. The orthographic projections of the second portion 132 and the third portion 133 on the substrate 101 fall into the region outside the first overlapping region 106, and thus the second portion 132 and the third portion 133 are the extension portion of the first electrode 103. The orthographic projection of the extension portion of the first electrode 103 on the substrate 101 falls into a region outside the orthographic projection of the upper electrode lead (the electrode lead 151) on the substrate 101. As illustrated in FIG. 1, the extension portion of the first electrode 103 is set around the first overlapping region 106 and is not closed.

It is to be noted that the first electrode 103 may include multiple portions. The portion(s) of the orthographic projection (which falls into the region outside the first overlapping region 106) of the first electrode 103 on the substrate 101 is (are) all the extension portion of the first electrode 103. Exemplarily, a combination of the orthographic projection of the extension portion of the first electrode 103 on the substrate 101 and the orthographic projection of the upper electrode lead on the substrate 101 is a closed loop.

In some embodiments, referring to FIG. 14, the bulk acoustic wave resonance structure further includes a third gap 109 and a fourth gap 110. The third gap 109 is located between the piezoelectric layer 104, and the second and the third portions 132 and 133; and the fourth gap 110 is located between the electrode lead 151 and the piezoelectric layer 104.

In a practical application, the materials of the third gap 109 and the fourth gap 110 include air or a functional material for reflecting acoustic waves. The materials of the third gap 109 and the fourth gap 110 may be the same or different. Exemplarily, the materials of the third gap 109 and the fourth gap 110 include air.

As illustrated in FIG. 14, the third gap 109 and the fourth gap 110 are located in the non-resonance region outside the first overlapping region 106. In this way, when a transverse shear wave propagates to the non-resonance region, the third gap 109 and the fourth gap 110 may reduce or even suppress the leakage of the transverse shear wave.

As illustrated in FIG. 14, the second portion 132 and the third portion 133 of the first electrode 103 are in contact with the third gap 109. The material of the third gap 109 includes air, and the second portion 132 and the third portion 133 of the first electrode 103 are both exposed to air. Compared to the first gap 107 that exposes the edge of the third portion 133 (for example, as illustrated in FIG. 12), the third gap 109 exposes the second portion 132 and the third portion 133 of the first electrode 103, which may further weaken the electric field intensity of the non-resonance region and reduce the parasitic resonance.

Compared to the manner in which no gap is between the electrode lead 151 and the piezoelectric layer 104 (for example, as illustrated in FIG. 13), the fourth gap 110 is set between the electrode lead 151 and the piezoelectric layer 104, which may increase the length of the electrode lead 151, further weaken the electric field intensity of the non-resonance region and reduce the parasitic resonance.

In the embodiment of the disclosure, the third gap 109 and the fourth gap 110 may reduce the leakage of transverse shear waves and increase the Q value of the bulk acoustic wave resonance structure. Preferably, the materials of the third gap 109 and the fourth gap 110 include air, which may further weaken the electric field intensity of the non-resonance region, and is more conducive to increasing acoustic wave energy of the main resonance mode of the bulk acoustic wave resonance structure.

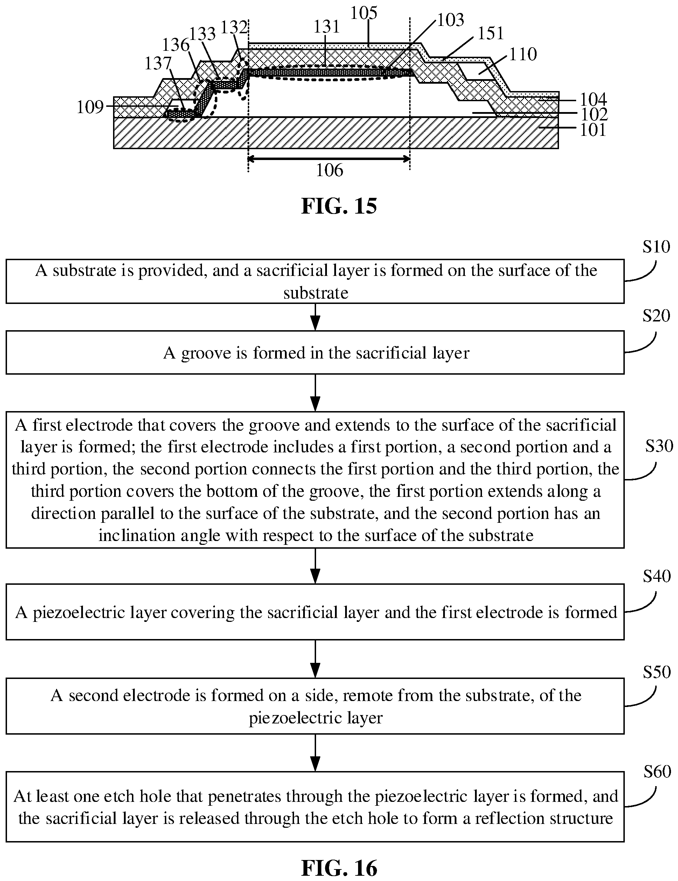

In some embodiments, referring to FIG. 15, the first electrode 103 further includes a sixth portion 136 and a seventh portion 137. The orthographic projection of the sixth portion 136 on the substrate 101 and the orthographic projection of the seventh portion 137 on the substrate 101 fall into the region outside the first overlapping region 106, the sixth portion 136 has an inclination angle with respect to the surface of the substrate 101, and the seventh portion 137 extends along the direction parallel to the surface of the substrate 101.

The sixth portion 136 connects the third portion 133 and the seventh portion 137, the third portion 133 is higher than the seventh portion 137 in the direction perpendicular to the surface of the substrate 101, and the seventh portion 137 is in direct contact with the substrate 101.

As illustrated in FIG. 15, the first electrode 103 has two slopes (for example, as the second portion 132 and the sixth portion 136 in FIG. 15). The sixth portion 136 extends to the substrate 101 and is in direct contact with the substrate 101, which makes the bulk acoustic wave resonance structure more stable. The direct contact between the sixth portion 136 and the substrate 101 can realize the heat dissipation through the substrate 101, which further improves the performance of the bulk acoustic wave resonance structure.

It is to be noted that the third gap 109 and the fourth gap 110 illustrated in FIG. 15 may be referred to the roles of the third gap 109 and the fourth gap 110 of the bulk acoustic wave resonance structure as illustrated in FIG. 14 and will not be repeated herein.

In the embodiment of the disclosure, the first electrode 103 has multiple slopes (for example, two slopes). Compared to the manner in which the first electrode 103 is set with only one slope, in the disclosure, by setting a first electrode 103 with multiple slopes, the distance between the first electrode 103 and the second electrode 105 in the non-resonance region can be further increased, the electric field intensity of the non-resonance region adjacent to the first overlapping region 106 can be decreased, and the parasitic resonance at the edge of the first overlapping region 106 can be reduced to reduce the propagation of the parasitic resonance to the resonance region, thereby improving the Q value of the bulk acoustic wave resonance structure. In addition, the third gap 109 and the fourth gap 110 can reduce the leakage of transverse shear waves and further increase the Q value of the bulk acoustic wave resonance structure.

In some embodiments, the sum of the length of the second portion 132 and the length of the third portion 133 is greater than or equal to 0.2 µm. It is to be noted that the first electrode 103 may include multiple portions. The portion(s) of the orthographic projection (which falls into the region outside the first overlapping region 106) of the first electrode 103 on the substrate 101 is (are) all the extension portion of the first electrode 103. As illustrated in FIG. 2, the orthographic projection of the extension portion on the substrate 101 has a length of L. Exemplarily, the length L is greater than or equal to 0.2 µm. Preferably, the length L is 1.5 µm to 3.5 µm.

In an example, the first electrode 103 includes the first portion 131, the second portion 132, and the third portion 133. The orthographic projections of the second portion 132 and the third portion 133 on the substrate 101 fall into the region outside the first overlapping region 106, and thus the second portion 132 and the third portion 133 are the extension portion of the first electrode 103. The length of the extension portion of the first electrode 103 is the sum of the lengths of the orthographic projections of the second portion 132 and the third portion 133 on the substrate 101.

In another example, the first electrode 103 includes the first portion 131 and the second portion 132, and the orthographic projection of the second portion 132 on the substrate 101 falls into the region outside the first overlapping region 106. The length of the extension portion of the first electrode 103 is the length of the orthographic projection of the second portion 132 on the substrate 101. Exemplarily, the length of the orthographic projection of the second portion 132 on the substrate 101 is 0.2 µm.

An embodiment of the disclosure provides an acoustic wave device including the bulk acoustic wave resonance structure according to the aforementioned embodiments. In the embodiment of the disclosure, the specific illustration of the bulk acoustic wave resonance structure in the acoustic wave device may be referred to the bulk acoustic wave resonance structure in the aforementioned embodiments and will not be repeated herein.

FIG. 16 is a first flowchart of a preparation method of a bulk acoustic wave resonance structure according to an embodiment of the disclosure. Based on the aforementioned bulk acoustic wave resonance structure, an embodiment of the disclosure provides a preparation method of a bulk acoustic wave resonance structure. As illustrated in FIG. 16, the method includes the following operations.

In operation S10, a substrate is provided, and a sacrificial layer is formed on the surface of the substrate.

In operation S20, a groove is formed in the sacrificial layer.

In operation S30, a first electrode that covers the groove and extends to the surface of the sacrificial layer is formed. Here, the first electrode includes a first portion, a second portion and a third portion, the second portion connects the first portion and the third portion, the third portion covers the bottom of the groove, the first portion extends along a direction parallel to the surface of the substrate, and the second portion has an inclination angle with respect to the surface of the substrate.

In operation S40, a piezoelectric layer covering the sacrificial layer and the first electrode is formed.

In operation S50, a second electrode is formed on a side (remote from the substrate) of the piezoelectric layer.

In operation S60, at least one etch hole that penetrates through the piezoelectric layer is formed, and the sacrificial layer is released through the etch hole to form a reflection structure.

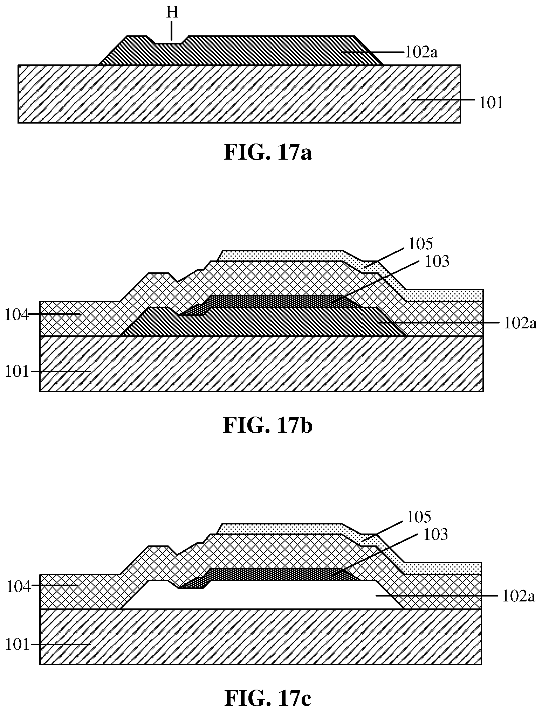

The composition materials of the substrate, the first electrode, the piezoelectric layer, the second electrode, and the reflection structure may be referred to the relevant description of the embodiments of the aforementioned bulk acoustic wave resonance structure and will not be repeated herein. It is to be noted that FIG. 1 to FIG. 15 are schematic drawings of the bulk acoustic wave resonance structure shown in the disclosure, and the sidewall angles of the first electrode 103 (the lower electrode) and the second electrode 105 (the upper electrode) illustrated in FIG. 1 to FIG. 15 are 90°. FIG. 17a to FIG. 17c and FIG. 19a to FIG. 23d are sectional schematic diagrams of a process of a preparation method of a bulk acoustic wave resonance structure shown in the disclosure, and the sidewall angles of the first electrode 103 (the lower electrode) and the second electrode 105 (the upper electrode) in the preparation process are less than 90°, which conforms more to the actual preparation of the bulk acoustic wave resonance structure.

FIG. 17a to FIG. 17c are sectional schematic diagrams of a process of a preparation method of a bulk acoustic wave resonance structure according to an exemplary embodiment. Referring to FIG. 17a, the operations S10 to S20 are performed. In some embodiments, a sacrificial material is deposited on the substrate 101, and the sacrificial material is etched to form a sacrificial layer 102a. Exemplarily, the composition material of the sacrificial layer 102a includes phosphosilicate glass (PSG), silicon dioxide, or the like, but is not limited thereto. The case where the composition material of the sacrificial layer 102a is silicon dioxide is illustrated as an example. Silane (SiH₄) and oxygen (O₂) may be used as the reaction gas to form the sacrificial layer 102a on a first surface of the substrate 101 by a chemical vapor deposition process.

As illustrated in FIG. 17a, the sacrificial layer 102a may be formed on the substrate 101, and the sacrificial layer 102a protrudes from the upper surface of the substrate 101. The sacrificial layer 102a may be removed in a subsequent process to form an upwardly protruded cavity-type reflection structure 102 (refer to FIG. 17c).

Referring to FIG. 17a, a groove H is formed in the sacrificial layer 102a by an etching process. The bottom of the groove H is parallel to the surface of the substrate 101, and the sidewalls of the groove H have inclination angles with respect to the surface of the substrate 101. Exemplarily, a range of the inclination angle is from 10° to 80°. The inclination angle may also be improved according to the design dimensions of the bulk acoustic wave resonance structure.

Referring to FIG. 17b, the operations S30 to S50 are performed. A first electrode material that covers the bottom and sidewalls of the groove H and extends to the surface of the sacrificial layer 102a is formed, and the first electrode material is patterned to form a first electrode 103. A piezoelectric layer 104 covering the sacrificial layer 102a and the first electrode 103 is formed. A second electrode material covering the surface of the piezoelectric layer 104 is formed, and the second electrode material is patterned to form a second electrode 105.

In a practical application, the overlapping region of the orthographic projection of the first electrode 103 on the substrate 101, the orthographic projection of the piezoelectric layer 104 on the substrate 101, and the orthographic projection of the second electrode 105 on the substrate 101 is a first overlapping region 106. The first overlapping region 106 may be referred to as a resonance region or an active region, and the region outside the first overlapping region 106 may be referred to as a non-resonance region.

It is to be noted that before the first electrode 103 is deposited, a seed layer may be deposited for improving the crystallographic axis orientation of the lower electrode material, such that the lattice is closer to the piezoelectric layer, and lattice defects in the subsequently deposited piezoelectric layer are reduced. Further, the seed layer may also be used as an etch blocking layer of the first electrode 103. The composition material of the seed layer is the same as the composition material of the piezoelectric layer.

Referring to FIG. 17c, the operation S60 is performed. An etch hole is formed, and the sacrificial layer 102a is released through the etch hole to form a reflection structure 102. In an embodiment, etchant is released through the etch hole to remove the sacrificial layer 102a. The etch hole may penetrate through the piezoelectric layer 104 and the sacrificial layer 102a to expose the surface of the substrate 101. In another embodiment, the etch hole may only penetrate through the piezoelectric layer 104 to expose the surface of the sacrificial layer 102a, that is, the etch hole may not have to penetrate through the sacrificial layer 102a.

Exemplarily, suitable etchant may be selected and injected into the etch hole, such that the etchant contacts and chemically reacts with the exposed sacrificial layer 102a to produce a gaseous product, and then the sacrificial layer 102a is removed. Specifically, in case that the composition material of the sacrificial layer 102a is silicon dioxide, a process of dry etching may be adopted, and hydrogen fluoride (HF) may be selected as the etchant to remove the sacrificial layer 102a. After hydrogen fluoride reacts with the sacrificial layer 102a exposed through the etch hole, gaseous silicon tetrafluoride (SiF₄) and gaseous water are produced.

In some embodiments, the method further includes the following operation. The second electrode 105 is thinned. The thickness and volume of the bulk acoustic wave resonance structure may be further reduced by thinning, which is conducive to miniaturization and integration of the bulk acoustic wave resonance structure.

In the embodiment of the disclosure, in the region outside the first overlapping region 106, i.e., the non-resonance region, by setting a first electrode 103 that has a slope, the distance between the first electrode 103 and the second electrode 105 in the non-resonance region is increased, the electric field intensity of the non-resonance region adjacent to the first overlapping region 106 is reduced, and the parasitic resonance at the edge of the first overlapping region 106 is reduced, to reduce the propagation of the parasitic resonance to the resonance region, thereby improving the Q value of the bulk acoustic wave resonance structure.

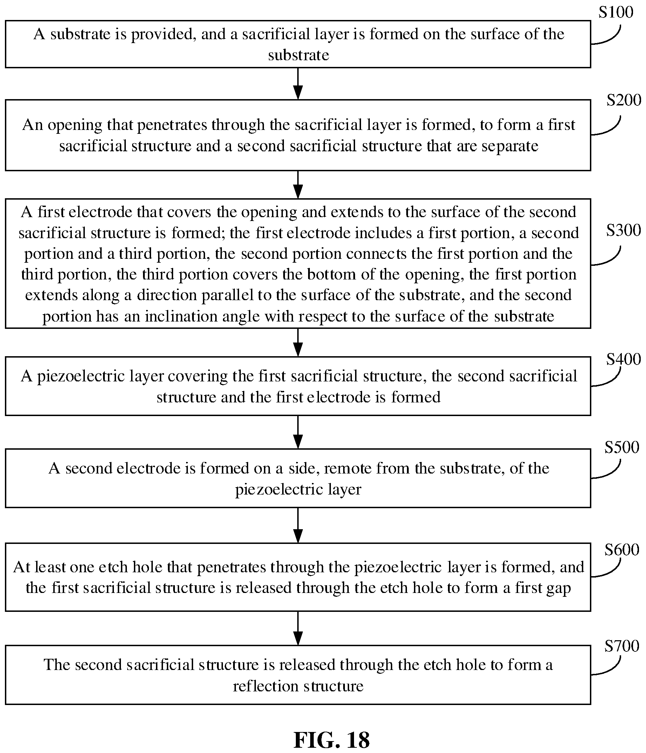

FIG. 18 is a second flowchart of a preparation method of a bulk acoustic wave resonance structure according to an exemplary embodiment. Based on the aforementioned bulk acoustic wave resonance structure, an embodiment of the disclosure provides a preparation method of a bulk acoustic wave resonance structure. As illustrated in FIG. 18, the method includes the following operations.

In operation S100, a substrate is provided, and a sacrificial layer is formed on the surface of the substrate.

In operation S200, an opening that penetrates through the sacrificial layer is formed, to form a first sacrificial structure and a second sacrificial structure that are separated.

In operation S300, a first electrode that covers the opening and extends to the surface of the second sacrificial structure is formed. Here, the first electrode includes a first portion, a second portion and a third portion, the second portion connects the first portion and the third portion, the third portion covers the bottom of the opening, the first portion extends along a direction parallel to the surface of the substrate, and the second portion has an inclination angle with respect to the surface of the substrate.

In operation S400, a piezoelectric layer covering the first sacrificial structure, the second sacrificial structure and the first electrode is formed.

In operation S500, a second electrode is formed on a side (remote from the substrate) of the piezoelectric layer.

In operation S600, at least one etch hole that penetrates through the piezoelectric layer is formed, and the first sacrificial structure is released through the etch hole to form a first gap.

In operation S700, the second sacrificial structure is released through the etch hole to form a reflection structure.

Here, the case where the bulk acoustic wave resonance structure further includes a first gap 107 is illustrated as an example. It is to be noted that the specific process of forming the substrate 101, the reflection structure 102, the first electrode 103, the piezoelectric layer 104, and the second electrode 105 in the operations S100 to S700 may be referred to the description in the aforementioned first flowchart.

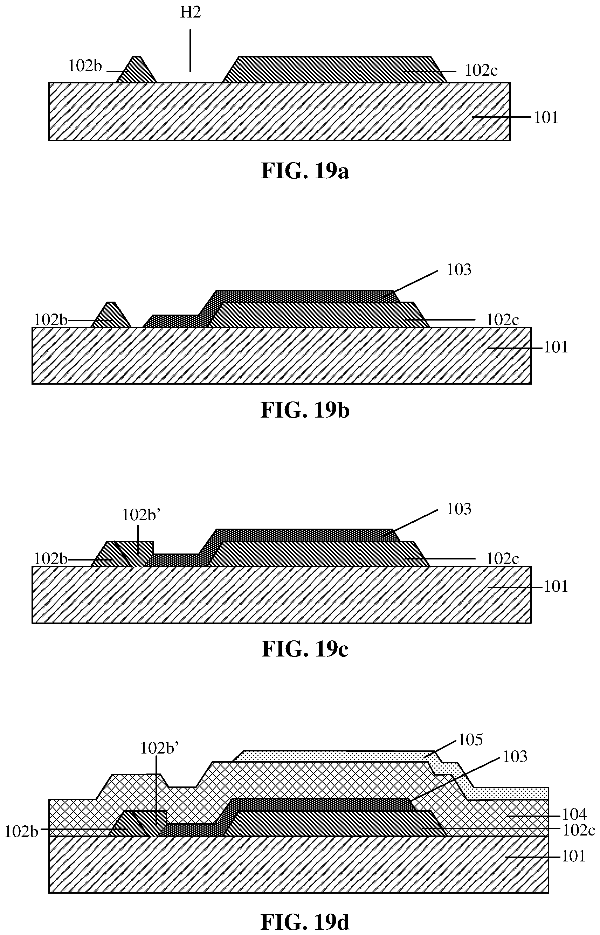

FIG. 19a to FIG. 19e are sectional schematic diagrams of a process of a preparation method of a bulk acoustic wave resonance structure according to an embodiment of the disclosure. Referring to FIG. 19a, the operations S100 to S200 are performed. In some embodiments, a sacrificial material is deposited on the substrate 101, and the sacrificial material is etched to form a sacrificial layer. As illustrated in FIG. 19a, an opening H2 that penetrates through the sacrificial layer is formed, to form a first sacrificial structure 102b and a second sacrificial structure 102c that are separated.

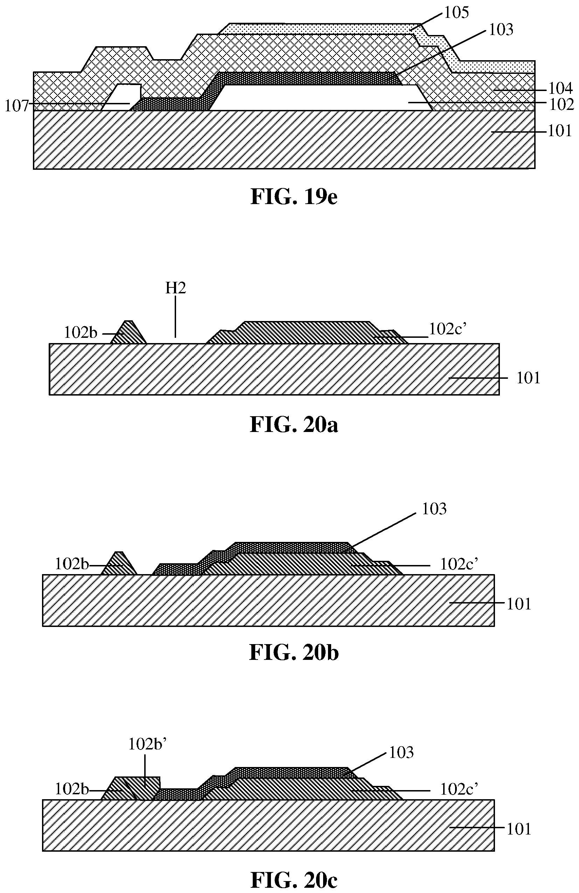

The first sacrificial structure 102b and the second sacrificial structure 102c are formed on the substrate 101, and the first sacrificial structure 102b and the second sacrificial structure 102c protrude from the upper surface of the substrate 101. The second sacrificial structure 102c may be removed in a subsequent process to form an upwardly protruded cavity-type reflection structure 102 (refer to FIG. 19e).

Referring to FIG. 19a, an opening H2 is formed in the sacrificial layer by an etching process. The bottom of the opening H2 is parallel to the surface of the substrate 101, and the sidewalls of the opening H2 have inclination angles with respect to the surface of the substrate 101. Exemplarily, a range of the inclination angle is from 10° to 80°. The inclination angle may also be improved according to the design dimensions of the bulk acoustic wave resonance structure.

Referring to FIG. 19b, the operation S300 is performed. It is to be noted that the sidewall angle of the first electrode 103 (the lower electrode) in the preparation process is less than 90°, which conforms more to the actual preparation of the bulk acoustic wave resonance structure. Referring to FIG. 19c, after the first electrode 103 is formed, another layer of sacrificial material is formed between the left side of the first electrode 103 and the first sacrificial structure 102b, to form a gap sacrificial structure 102b'. The first sacrificial structure 102b and the gap sacrificial structure 102b' may be removed in a subsequent process to form a first gap 107 (refer to FIG. 19e), such that the left side of the first electrode 103 is in contact with the first gap 107.

Referring to FIG. 19d, the operations S400 to S500 are performed. A piezoelectric layer 104 covering the first sacrificial structure 102b, the gap sacrificial structure 102b', and the first electrode 103 is formed. A second electrode material covering the surface of the piezoelectric layer 104 is formed, and the second electrode material is patterned to form a second electrode 105.

In a practical application, the overlapping region of the orthographic projection of the first electrode 103 on the substrate 101, the orthographic projection of the piezoelectric layer 104 on the substrate 101, and the orthographic projection of the second electrode 105 on the substrate 101 is a first overlapping region 106. The first overlapping region 106 may be referred to as a resonance region or an active region, and the region outside the first overlapping region 106 may be referred to as a non-resonance region.

Referring to FIG. 19e, the operation S600 is performed. Etch hole(s) is/are formed, and the second sacrificial structure 102c is released through the etch hole(s) to form a reflection structure 102. The first sacrificial structure 102b is released through the etch hole(s) to form a first gap 107. The specific process of the operation S600 may be referred to the description of the operation S60 in the first flowchart illustrated in FIG. 16 and will not be repeated herein.

In the embodiment of the disclosure, in the region outside the first overlapping region 106, i.e., the non-resonance region, by setting a first electrode 103 that has a slope, the distance between the first electrode 103 and the second electrode 105 in the non-resonance region is increased, the electric field intensity of the non-resonance region adjacent to the first overlapping region 106 is reduced, and the parasitic resonance at the edge of the first overlapping region 106 is reduced, to reduce the propagation of the parasitic resonance to the resonance region, thereby improving the Q value of the bulk acoustic wave resonance structure. The first gap 107 may reduce the leakage of transverse shear waves and increase the Q value of the bulk acoustic wave resonance structure. Preferably, the material of the first gap 107 includes air, which may further weaken the electric field intensity of the non-resonance region, and is more conducive to increasing acoustic wave energy of the main resonance mode of the bulk acoustic wave resonance structure.

The case where the first electrode 103 of the bulk acoustic wave resonance structure includes two slopes is illustrated as an example. An embodiment of the disclosure shows a preparation method of a bulk acoustic wave resonance structure, and the method includes the following operations.

FIG. 20a to FIG. 20e are sectional schematic diagrams of a process of a preparation method of a bulk acoustic wave resonance structure according to an embodiment of the disclosure. As illustrated in FIG. 20a, a first sacrificial structure 102b and a third sacrificial structure 102c' are formed on the substrate 101. Specifically, the substrate 101 is provided, a sacrificial material is deposited on the substrate 101, and the sacrificial material is etched to form a sacrificial layer. An opening H2 that penetrates through the sacrificial layer is formed, to form a first sacrificial structure 102b and a second sacrificial structure 102c that are separated. The process may be referred to FIG. 19a and will not be repeated herein. The second sacrificial structure 102c is partially etched to form a third sacrificial structure 102c' that has steps (as illustrated in FIG. 20a).

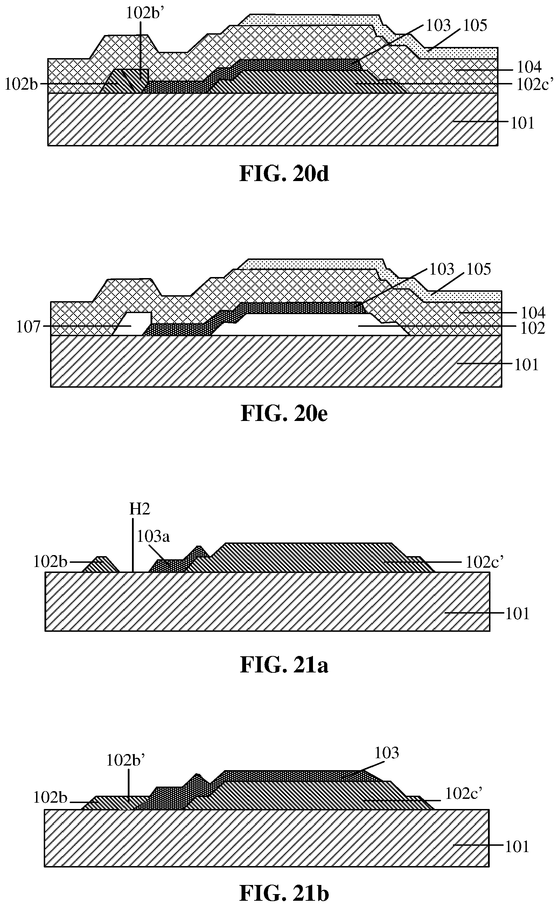

As illustrated in FIG. 20b, a first electrode 103 that covers the opening H2 and extends to the surface of the third sacrificial structure 102c' is formed. It is to be noted that the sidewall angle of the first electrode 103 (the lower electrode) in the preparation process is less than 90°, which conforms more to the actual preparation of the bulk acoustic wave resonance structure. Referring to FIG. 20c, after the first electrode 103 is formed, another layer of sacrificial material is formed between the left side of the first electrode 103 and the first sacrificial structure 102b, to form a gap sacrificial structure 102b'. The first sacrificial structure 102b and the gap sacrificial structure 102b' may be removed in a subsequent process to form a first gap 107 (refer to FIG. 20e), such that the left side of the subsequent first electrode 103 is in contact with the first gap 107.

As illustrated in FIG. 20d, a piezoelectric layer 104 covering the first sacrificial structure 102b, the gap sacrificial structure 102b', the third sacrificial structure 102c', and the first electrode 103 is formed. A second electrode 105 is formed on a side (remote from the substrate) of the piezoelectric layer 104. The specific process of the operation may be referred to the description of the operations S300 to S500 in the aforementioned second flowchart and will not be repeated herein.

As illustrated in FIG. 20e, at least one etch hole that penetrates through the piezoelectric layer 104 is formed, and the first sacrificial structure 102b is released through the etch hole to form a first gap 107. The third sacrificial structure 102c' is released through the etch hole to form a reflection structure 102. The specific process of the operation may be referred to the description of the operations S600 to S700 in the aforementioned second flowchart and will not be repeated herein.

The case where the bulk acoustic wave resonance structure includes the structure as illustrated in FIG. 11 is illustrated as an example. An embodiment of the disclosure shows a preparation method of a bulk acoustic wave resonance structure, and the method includes the following operations.

FIG. 21a to FIG. 21d are sectional schematic diagrams of a process of a preparation method of a bulk acoustic wave resonance structure according to an embodiment of the disclosure. As illustrated in FIG. 21a, a first sacrificial structure 102b and a third sacrificial structure 102c' are formed on the substrate 101. The process may be referred to the description of FIG. 20a and will not be repeated herein. A first protrusion 103a is deposited on a side (close to the first sacrificial structure 102b) of the third sacrificial structure 102c'. The composition material of the first protrusion 103a is the same as the composition material of the first electrode 103.

As illustrated in FIG. 21b, a first electrode material layer that covers the opening H2 and the first protrusion 103a and extends to the surface of the third sacrificial structure 102c' is formed. The first protrusion 103a and the first electrode material layer form the first electrode 103. It is to be noted that the sidewall angle of the first electrode 103 (the lower electrode) in the preparation process is less than 90°, which conforms more to the actual preparation of the bulk acoustic wave resonance structure. Referring to FIG. 21b, after the first electrode 103 is formed, another layer of sacrificial material is formed between the left side of the first electrode 103 and the first sacrificial structure 102b, to form a gap sacrificial structure 102b'. The first sacrificial structure 102b and the gap sacrificial structure 102b' may be removed in a subsequent process to form a first gap 107 (refer to FIG. 20e), such that the left side of the subsequent first electrode 103 is in contact with the first gap 107.

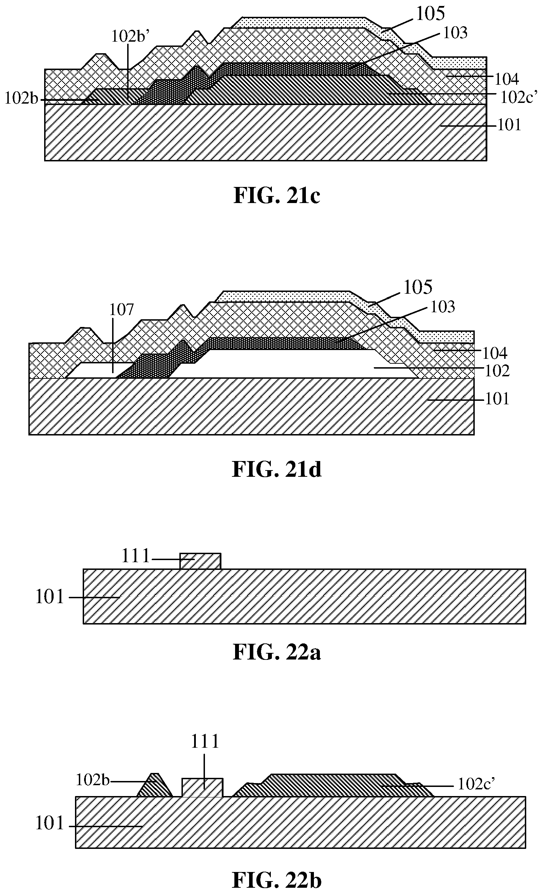

As illustrated in FIG. 21c, a piezoelectric layer 104 covering the first sacrificial structure 102b, the gap sacrificial structure 102b', the third sacrificial structure 102c', and the first electrode 103 is formed. A second electrode 105 is formed on a side (remote from the substrate) of the piezoelectric layer 104. The specific process of the operation may be referred to the description of the operations S300 to S500 in the aforementioned second flowchart and will not be repeated herein.

As illustrated in FIG. 21d, at least one etch hole that penetrates through the piezoelectric layer 104 is formed, and the first sacrificial structure 102b is released through the etch hole to form a first gap 107. The third sacrificial structure 102c' is released through the etch hole to form a reflection structure 102. The specific process of the operation may be referred to the description of the operations S600 to S700 in the aforementioned second flowchart and will not be repeated herein.

The case where the bulk acoustic wave resonance structure includes the structure as illustrated in FIG. 12 is illustrated as an example. An embodiment of the disclosure shows a preparation method of a bulk acoustic wave resonance structure, and the method includes the following operations.

FIG. 22a to FIG. 22f are sectional schematic diagrams of a process of a preparation method of a bulk acoustic wave resonance structure according to an embodiment of the disclosure. As illustrated in FIG. 22a, a substrate material is provided, and the substrate material is etched to form a substrate 101 and a first protrusion 111 located on the substrate.

As illustrated in FIG. 22b, a first sacrificial structure 102b and a third sacrificial structure 102c' are formed on the substrate 101. The process may be referred to the description of FIG. 20a and will not be repeated herein.

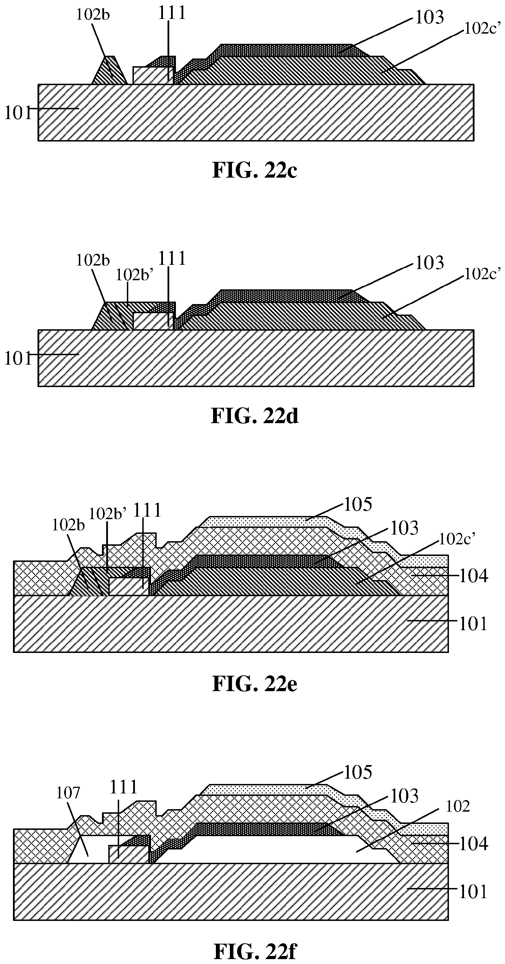

As illustrated in FIG. 22c, a first electrode 103 covering the first protrusion 111 and the third sacrificial structure 102c' is formed. It is to be noted that the sidewall angle of the first electrode 103 (the lower electrode) in the preparation process is less than 90°, which conforms more to the actual preparation of the bulk acoustic wave resonance structure. Referring to FIG. 22d, after the first electrode 103 is formed, another layer of sacrificial material is formed between the left side of the first electrode 103 and the first sacrificial structure 102b, to form a gap sacrificial structure 102b'. The first sacrificial structure 102b and the gap sacrificial structure 102b' may be removed in a subsequent process to form a first gap 107 (refer to FIG. 20e), such that the left side of the subsequent first electrode 103 is in contact with the first gap 107.

Referring to FIG. 22e, a piezoelectric layer 104 covering the first sacrificial structure 102b, the gap sacrificial structure 102b', the third sacrificial structure 102c', and the first electrode 103 is formed. A second electrode 105 is formed on a side (remote from the substrate) of the piezoelectric layer 104. The specific process of the operation may be referred to the description of the operations S300 to S500 in the aforementioned second flowchart and will not be repeated herein.

As illustrated in FIG. 22f, at least one etch hole that penetrates through the piezoelectric layer 104 is formed, and the first sacrificial structure 102b is released through the etch hole to form a first gap 107. The third sacrificial structure 102c' is released through the etch hole to form a reflection structure 102. The specific process of the operation may be referred to the description of the operations S600 to S700 in the aforementioned second flowchart and will not be repeated herein.

The case where the bulk acoustic wave resonance structure includes a second gap 108 is illustrated as an example. An embodiment of the disclosure shows a preparation method of a bulk acoustic wave resonance structure, and the method includes the following operations.

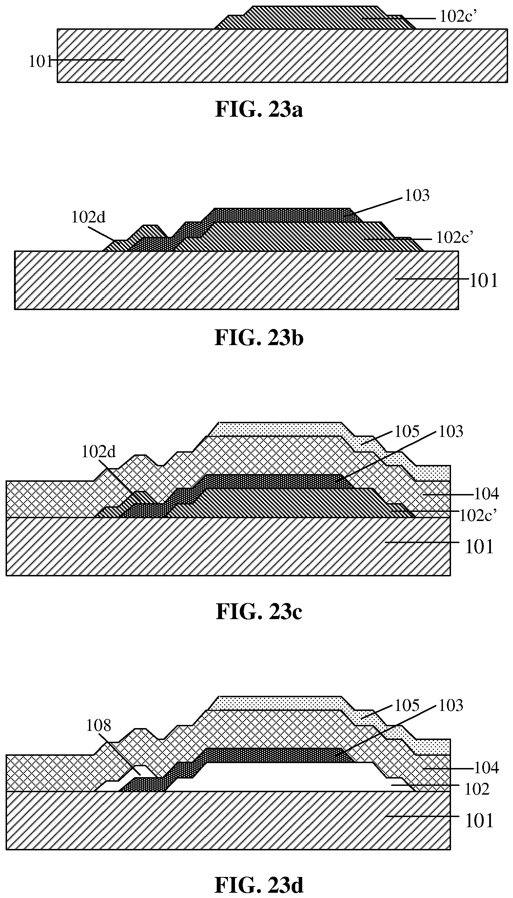

FIG. 23a to FIG. 23d are sectional schematic diagrams of a process of a preparation method of a bulk acoustic wave resonance structure according to an embodiment of the disclosure. As illustrated in FIG. 23a, a substrate 101 is provided, and a third sacrificial structure 102c' is formed on the substrate 101. The formation process of the third sacrificial structure 102c' may be referred to the description of the aforementioned embodiments and will not be repeated herein.

As illustrated in FIG. 23b, a first electrode 103 covering the third sacrificial structure 102c' is formed, and a second protrusion 102d covering the edge of the first electrode 103 is formed. The composition material of the second protrusion 102d is the same as the composition material of the third sacrificial structure 102c'.

As illustrated in FIG. 23c, a piezoelectric layer 104 covering the second protrusion 102d, the first electrode 103, and the third sacrificial structure 102c' is formed. A second electrode 105 is formed on a side (remote from the substrate) of the piezoelectric layer 104. The specific process of the operation may be referred to the description of the operations S300 to S500 in the aforementioned second flowchart and will not be repeated herein.

As illustrated in FIG. 23d, at least one etch hole that penetrates through the piezoelectric layer 104 is formed, and the second protrusion 102d is released through the etch hole to form a second gap 108. The third sacrificial structure 102c' is released through the etch hole to form a reflection structure 102. The specific process of the operation may be referred to the description of the operations S600 to S700 in the aforementioned second flowchart and will not be repeated herein.

In some embodiments, the preparation method of the bulk acoustic wave resonance structure as illustrated in FIG. 7 may be referred to FIG. 21a to FIG. 21c, a third sacrificial structure 102c' is formed on the substrate 101 (without forming the first sacrificial structure 102b). A first protrusion 103a is deposited on the edge of a side of the third sacrificial structure 102c'. The composition material of the first protrusion 103a is the same as the composition material of the first electrode 103. A first electrode material layer that covers the opening H2 and the first protrusion 103a and extends to the surface of the third sacrificial structure 102c' is formed, and the first protrusion 103a and the first electrode material layer form the first electrode 103. A piezoelectric layer 104 covering the third sacrificial structure 102c' and the first electrode 103 is formed, and a second electrode 105 is formed on a side (remote from the substrate) of the piezoelectric layer 104. At least one etch hole that penetrates through the piezoelectric layer 104 is formed, and the third sacrificial structure 102c' is released through the etch hole to form a reflection structure 102.

In some embodiments, the preparation method of the bulk acoustic wave resonance structure as illustrated in FIG. 8 may be referred to FIG. 22a to FIG. 22d, a first protrusion 111 and a third sacrificial structure 102c' are formed on the substrate 101 (without forming the first sacrificial structure 102b). A first electrode 103 covering the first protrusion 111 and the third sacrificial structure 102c' is formed. A piezoelectric layer 104 covering the third sacrificial structure 102c' and the first electrode 103 is formed, and a second electrode 105 is formed on a side (remote from the substrate) of the piezoelectric layer 104. At least one etch hole that penetrates through the piezoelectric layer 104 is formed, and the third sacrificial structure 102c' is released through the etch hole to form a reflection structure 102.

In some embodiments, such as FIG. 5, FIG. 14, and FIG. 15, in the process of depositing the first electrode 103, the number of slopes of the first electrode 103 and the inclination angles of the slopes may be naturally formed according to the surface morphology of the lower sacrificial layer, and the sacrificial layer is removed in a subsequent process to form a reflection structure 102. Specifically, a sacrificial layer is deposited on the substrate, and the composition material of the sacrificial layer includes SiO₂, but is not limited thereto. Photoresist is uniformly coated onto the sacrificial layer, a desired photoresist pattern is obtained by exposure and development, the sacrificial layer that is not covered by the photoresist is removed by etching, and finally, the photoresist is removed to form a first pattern sacrificial layer and a first angle. Photoresist is uniformly coated onto the first pattern sacrificial layer, to form a second angle by etching; and photoresist is continued to be uniformly coated, to form a third angle by etching. Here, the first angle, the second angle, and the third angle are respectively inclination angles of the sidewalls of the sacrificial layer with respect to the surface of the substrate, and a range of the inclination angle is from 10° to 80°.

It is to be noted that, according to the simulation test, the Q value of the bulk acoustic wave resonance structure as illustrated in FIG. 2 or FIG. 3 is about 1449.1, the Q value of the bulk acoustic wave resonance structure as illustrated in FIG. 4 is about 1443.3, the Q value of the bulk acoustic wave resonance structure as illustrated in FIG. 9 or FIG. 10 is about 1406.2, and the Q value of the bulk acoustic wave resonance structure as illustrated in FIG. 6 is about 1415.2. According to the test results, by setting a slope extension portion for the first electrode 103 of the bulk acoustic wave resonance structure, the distance between the first electrode 103 and the second electrode 105 in the non-resonance region can further be increased, and the electric field intensity of the non-resonance region adjacent to the first overlapping region 106 can be reduced, such that the parasitic resonance of the non-resonance region is reduced, thereby improving the Q value of the bulk acoustic wave resonance structure. The Q value of the improved bulk acoustic wave resonance structure may be improved by 10% to 20%.

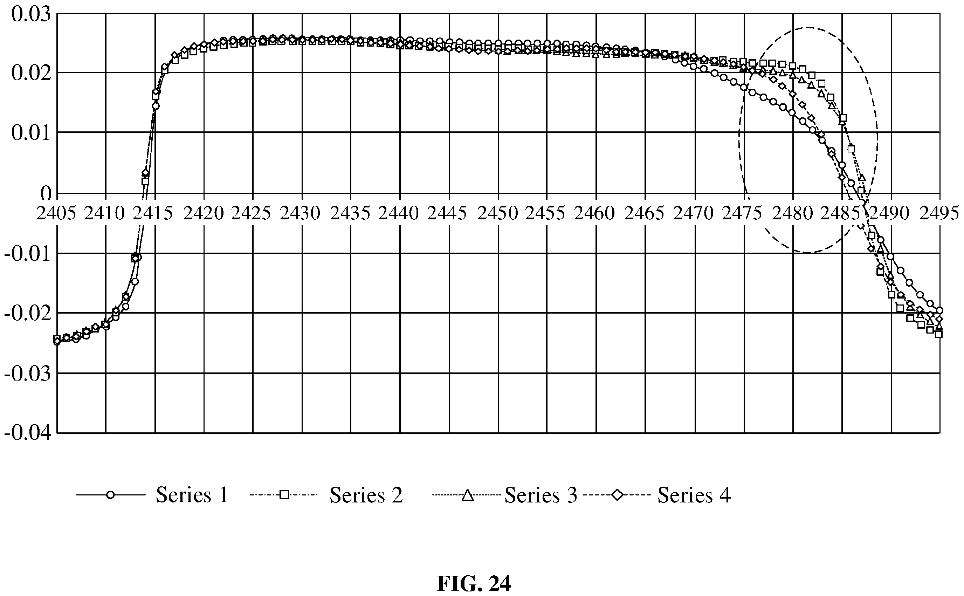

Referring to FIG. 24, tests are performed on the extension length of the first electrode 103 of the bulk acoustic wave resonance structure illustrated in FIG. 2. The extension length denotes the length L of the orthographic projection of the extension portion of the first electrode 103 on the substrate 101 (as illustrated in FIG. 2). As illustrated in FIG. 24, series 1 indicates that the extension length is 0; series 2 indicates that the extension length is 2 µm; series 3 indicates that the extension length is 3 µm; and series 4 indicates that the extension length is 3 µm, and the cusp of the end of the extension is rounded. According to the test results, as illustrated in the dashed box of FIG. 24, series 2 may effectively improve the inductance value and improve the signal suppression capability of the high-frequency band of the passband. Therefore, preferably, the extension length of the first electrode 103 is 2 µm to 3 µm.

The above is only the specific implementations of the disclosure, but the scope of protection of the disclosure is not limited thereto. Any variations or replacements apparent to those skilled in the art within the technical scope disclosed by the disclosure shall fall within the scope of protection of the disclosure.

## Claims

1. A bulk acoustic wave resonance structure, comprising:
a substrate; and
a reflection structure, a first electrode, a piezoelectric layer, and a second electrode that are sequentially located on the substrate; wherein an overlapping region of an orthographic projection of the first electrode on the substrate, an orthographic projection of the piezoelectric layer on the substrate, and an orthographic projection of the second electrode on the substrate is a first overlapping region;
wherein the first electrode comprises a first portion, a second portion, and a third portion, and the second portion connects the first portion and the third portion;
an orthographic projection of the first portion on the substrate falls into the first overlapping region, and the first portion extends along a direction parallel to a surface of the substrate;
an orthographic projection of the second portion on the substrate and an orthographic projection of the third portion on the substrate fall into a region outside the first overlapping region, the second portion has an inclination angle with respect to the surface of the substrate, and the third portion extends along the direction parallel to the surface of the substrate; and
the first portion is higher than the third portion in a direction perpendicular to the surface of the substrate.

2. The bulk acoustic wave resonance structure of claim 1, wherein the first electrode further comprises a fourth portion and a fifth portion;
an orthographic projection of the fourth portion on the substrate and an orthographic projection of the fifth portion on the substrate fall into the region outside the first overlapping region, the fourth portion has an inclination angle with respect to the surface of the substrate, and the fifth portion extends along the direction parallel to the surface of the substrate; and
the fourth portion connects the third portion and the fifth portion, the third portion is higher than the fifth portion in the direction perpendicular to the surface of the substrate, and the fifth portion is located between the piezoelectric layer and the substrate.

3. The bulk acoustic wave resonance structure of claim 2, wherein the fifth portion is in direct contact with the substrate.

4. The bulk acoustic wave resonance structure of claim 1, wherein the third portion is located between the piezoelectric layer and the substrate, and the third portion is in direct contact with the substrate; and
a side remote from the first overlapping region of the third portion is in contact with the piezoelectric layer.

5. The bulk acoustic wave resonance structure of claim 4, wherein a thickness of the third portion in the direction perpendicular to the surface of the substrate is greater than a thickness of the first portion in the direction perpendicular to the surface of the substrate.

6. The bulk acoustic wave resonance structure of claim 4, wherein the substrate comprises a first protrusion that protrudes toward the third portion, and the first protrusion is in direct contact with the third portion;
a side remote from the first overlapping region of the first protrusion is in contact with the piezoelectric layer; and
a side close to the first overlapping region of the first protrusion is in contact with the reflection structure.

7. The bulk acoustic wave resonance structure of claim 1, further comprising a first gap located between the piezoelectric layer and the substrate;
wherein a side remote from the first overlapping region of the third portion is in contact with the first gap.

8. The bulk acoustic wave resonance structure of claim 7, wherein the first gap has a first height in the direction perpendicular to the surface of the substrate, the third portion has a second height in the direction perpendicular to the surface of the substrate; the first height is equal to the second height, and the first height is less than a height of the reflection structure within the first overlapping region in the direction perpendicular to the surface of the substrate.

9. The bulk acoustic wave resonance structure of claim 7, further comprising a second protrusion that protrudes toward the third portion, wherein the second protrusion is in direct contact with the third portion; and
the first gap has a first height in the direction perpendicular to the surface of the substrate, the third portion has a second height in the direction perpendicular to the surface of the substrate, the second protrusion has a third height in the direction perpendicular to the surface of the substrate; and the first height is equal to a sum of the second height and the third height.

10. The bulk acoustic wave resonance structure of claim 1, further comprising a second gap, wherein the second gap is located between the piezoelectric layer, and the second and the third portions;
a side, close to the first overlapping region, of the second gap is in contact with the second portion; and
a side, close to the substrate of the second gap, is in contact with the third portion.

11. The bulk acoustic wave resonance structure of claim 1, further comprising an electrode lead connected to the second electrode, wherein an orthographic projection of the electrode lead on the substrate is located in the region outside the first overlapping region; and
the second portion and the third portion are set around the first overlapping region, and the orthographic projection of the second portion on the substrate and the orthographic projection of the third portion on the substrate fall into a region outside the orthographic projection of the electrode lead on the substrate.

12. The bulk acoustic wave resonance structure of claim 11, further comprising a third gap and a fourth gap, wherein the third gap is located between the piezoelectric layer, and the second and the third portions, and the fourth gap is located between the electrode lead and the piezoelectric layer.

13. The bulk acoustic wave resonance structure of claim 1, wherein a sum of a length of the second portion and a length of the third portion is greater than or equal to 0.2 µm.

14. An acoustic wave device, comprising the bulk acoustic wave resonance structure of any one of claims 1 to 13.

15. A preparation method of a bulk acoustic wave resonance structure, comprising:
providing a substrate, and forming a sacrificial layer on a surface of the substrate;
forming a groove in the sacrificial layer;
forming a first electrode that covers the groove and extends to a surface of the sacrificial layer; wherein the first electrode comprises a first portion, a second portion and a third portion, the second portion connects the first portion and the third portion, the third portion covers a bottom of the groove, the first portion extends along a direction parallel to the surface of the substrate, and the second portion has an inclination angle with respect to the surface of the substrate;
forming a piezoelectric layer covering the sacrificial layer and the first electrode;
forming a second electrode on a side, remote from the substrate, of the piezoelectric layer; and
forming at least one etch hole that penetrates through the piezoelectric layer, and releasing the sacrificial layer through the etch hole to form a reflection structure.

16. A preparation method of a bulk acoustic wave resonance structure, comprising:
providing a substrate, and forming a sacrificial layer on a surface of the substrate;
forming an opening that penetrates through the sacrificial layer, to form a first sacrificial structure and a second sacrificial structure that are separated;
forming a first electrode that covers the opening and extends to a surface of the second sacrificial structure; wherein the first electrode comprises a first portion, a second portion and a third portion, the second portion connects the first portion and the third portion, the third portion covers a bottom of the opening, the first portion extends along a direction parallel to the surface of the substrate, and the second portion has an inclination angle with respect to the surface of the substrate;
forming a piezoelectric layer covering the first sacrificial structure, the second sacrificial structure and the first electrode;
forming a second electrode on a side, remote from the substrate, of the piezoelectric layer;
forming at least one etch hole that penetrates through the piezoelectric layer, and releasing the first sacrificial structure through the etch hole to form a first gap; and
releasing the second sacrificial structure through the etch hole to form a reflection structure.
